# EUROPÄISCHE PATENTSCHRIFT

(11) **EP 0 852 774 B1**
(45) Veröffentlichungstag und Bekanntmachung des Hinweises auf die Patenterteilung: **03.02.1999**
(21) Anmeldenummer: 96929186.3
(22) Anmeldetag: 12.09.1996
(51) Int. Cl.: G06K 19/077

(54) **CHIPMODUL**
CHIP MODULE
MODULE DE PUCE

(30) Priorität: 27.09.1995 DE 19535989
(43) Veröffentlichungstag der Anmeldung: 15.07.1998
(73) Patentinhaber: SIEMENS AKTIENGESELLSCHAFT, 80333 München (DE)
(72) Erfinder: HOUDEAU, Detlef, D-93047 Regensburg (DE); KIRSCHBAUER, Josef, D-93476 Blaibach (DE); MENSCH, Hans-Georg, D-92431 Neunburg (DE); STAMPKA, Peter, D-92421 Schwandorf (DE); STECKHAN, Hans-Hinnerk, D-81827 München (DE)
(86) Internationale Anmeldenummer: DE9601725
(87) Internationale Veröffentlichungsnummer: WO9712341

(56) Entgegenhaltungen:
- DE-A- 4 427 309
- FR-A- 2 617 668
- US-A- 4 625 102
- IBM TECHNICAL DISCLOSURE BULLETIN, Bd. 32, Nr. 4A, September 1989, Seite 431/432 XP000039894 "RIGID DISH SMART CARD"

## Beschreibung

Die Erfindung betrifft ein Chipmodul zum Einbau in einen Kartengrundkörper einer Chipkarte.

Chipkarten sind im Stand der Technik hinlänglich bekannt. Die Anwendungsmöglichkeiten von Chipkarten sind äußerst vielseitig und nehmen mit der steigenden Rechenleistung und Speicherkapazität der verfügbaren, darin enthaltenen integrierten Schaltungen noch stetig zu. Damit geht jedoch eine Vergrößerung der einzubauenden integrierten Schaltungen (elektronische Bauelemente, Chips) einher.

Der Aufbau einer Chipkarte wird durch eine Vielzahl von Merkmalen bestimmt, die teilweise durch entsprechende Normen vorgegeben sind. Dies betrifft beispielsweise die Belastbarkeit der Karte in Bezug auf UV-Strahlung, Röntgenstrahlung, sowie die mechanische Belastbarkeit des Kartenkörpers und der elektrischen Kontakte oder auch die Temperaturbeständigkeit.

Bei der überwiegenden Anzahl der Herstellungsverfahren für Chipkarten wird der Chip zunächst auf einen flexiblen Film montiert. Auf diesem Film befinden sich die notwendigen Kartenkontakte. Aus dem fertig montierten Film werden dann die einzelnen Chipmodule ausgestanzt. Die Chips sind dabei mittelbar über den Träger des Modules in der Karte befestigt. Dies hat den Vorteil, daß Biegekräfte vom Chip ferngehalten werden. Der Chip ist dabei mit seiner Rückseite auf dem flexiblen Film montiert. Die auf seiner Vorderseite befindlichen elektrischen Anschlußflächen werden über Bonddrähte mit Kontaktierungen verbunden, die durch den flexiblen Film hindurch mit den Kartenkontakten verbunden sind. Die Chipvorderseite einschließlich der genannten Drähte wird in der Regel mit einer Abdeckung, beispielsweise einer Kunststoffmasse, vor Korrosionseinflüssen geschützt. Die genannten Ausführungen sind Teile von üblichen Verfahren zur Verpackung von Chips in Standardgehäusen.

Chipmodule für kontaktbehaftete Chipkarten werden nach dem heutigen Stand der Technik durch drei Grundtechnologien montiert:
a) Cyanacrylat-Klebetechnik
b) Hot-Melt-Klebetechnik
c) Contact-Adhäsiv-Klebetechnik.

Die unter c) genannte Technik wird auch Pressure-Sensitive-Klebung genannt. Dabei führt die durch mechanischen Druck erzeugte Scherspannung in der Klebeschicht zu einer Visositätserniedrigung des Klebstoffes, der den physikalischen Kontakt zum Verbindungselement, z.B. Kartengrundkörper, herstellt bzw. verbessert. Ein Beispiel für eine einlagige Hot-Melt-Klebetechnik liefert die deutsche Offenlegungsschrift DE 36 39 630. Ein Beispiel einer mehrlagigen Cyanacrylat-Klebetechnik liefert die europäische Patentanmeldung EP 0 527 438.

Für die Dauerhaltbarkeit einer Chipkarte ist insbesondere die Qualität der Verbindung zwischen dem Chipmodul und dem Kartenkörper maßgebend. Wird beispielsweise ein Chipmodul in eine in einen Kartenkörper ausgefräste Ausnehmung eingesetzt und dort eingeklebt, so kann dies mit einer wesentlichen Temperaturbelastung verbunden sein, wenn beispielsweise ein Hot-Melt-Klebstoff eingesetzt wird.

Unter Chipmodul wird ein Chipträger verstanden, der auf der Kontaktseite acht Kontakte aufweist. Auf der gegenüberliegenden Seite ist ein Halbleiterchip plaziert, der sich zwischen diesen Kontakten der Chipkarte befindet, d.h., der lateral gesehen, direkt gegenüber liegt. Solche Chipmodule sind aus der US 4,625,102 und der FR 2 617 668 bekannt. Während die Cyanacrylat- und die Contact-Adhäsiv-Klebetechnik mit niedrigen Prozeßtemperaturen zur Modulmontage auskommen, ist ein wesentliches Kennzeichen der Hot-Melt-Klebetechnik die vergleichsweise hohe Einbautemperatur. Übliche Temperaturen liegen im Bereich von 200 bis 250°C. Während der Modulimplantation, die weniger als 1,5 Sekunden dauert, wird bei dieser Verfahrensweise eine große Wärmemenge in das Chipmodul eingekoppelt. Damit wird nicht nur die Klebstoffschicht erwärmt, die das Chipmodul mit dem Kartengrundkörper verbindet, sondern auch das Chipträgerelement, der Halbleiterchip und die Abdeckmasse. Dabei ist gleichzeitig zu berücksichtigen, daß der Aufbau eines Chipmodules mehrere Bestandteile aus unterschiedlichen Werkstoffen beinhaltet. So kann gemäß der US 4,625,102 die flexible Folie, der Träger, beispielsweise aus einem Epoxidharz bestehen. Die einseitig darauf aufgebrachten Kontakte bestehen aus einem Metall, der Halbleiterchip aus einem Kristall, beispielsweise Silizium, die Bonddrähte aus Metall und die für die Chipvorderseite vorgesehene Abdeckmasse aus einem Kunststoff. Wird dieses System einer größeren Temperaturschwankung unterworfen, so können sog. Delaminationen, d.h. Auftrennungen zwischen aneinanderliegenden Schichten, die Folge sein. Bei einem Chipmodul der genannten Art ist die Verbindung, in der Regel eine Klebeverbindung, zwischen Chip und Träger unkritisch. Die kurzzeitige Erwärmung des gesamten Systemes führt aber nach längeren Lager- und Transportzeiten der Module zu lokalen Defekten in der Abdeckmasse, die als Delamination bezeichnet werden. Delaminationen zwischen dem Chip und der Abdeckmasse können zu Fehlfunktionen oder zum Ausfall des Chipmodules führen. Dies ist darin begründet, daß eine Delamination in diesem Bereich ein Abreißen von elektrischen Leitern, nämlich den Bonddrähten, durch die der Chip mit den äußeren Kontakten verbunden ist, nach sich zieht. Das obengenannte Hot-Melt-Verfahren zum Einkleben eines Chipmodules in einen Kartenkörper ist mit einer entsprechend hohen Wärmebelastung des Chipmodules verbunden.

Die unter ultraviolettem Licht aushärtenden Abdeckmassen sind besonders anfällig in bezug auf eine Delamination. Ursache hierfür sind die thermisch induzierten Spannungen im Gesamtsystem des Chipmodules. Diese Spannungen existieren auf Grund von dilathermischen Fehlanpassungen zwischen Halbleiterchip, Chipträgerelement und Abdeckmasse. Die diesbezüglichen Temperaturausdehnungskoeffizienten verhalten sich in gleichen Temperaturbereichen wie 2,5:10:18. Die Wahrscheinlichkeit des Auftretens von Delaminationen steigt mit der Vergrößerung des Halbleiterchips und der Erhöhung der Transport- und Lagerzeit. In der genannten Zeit nimmt die Abdeckmasse aus der Umgebungsluft Feuchtigkeit auf, die zu einer Materialausdehnung führt, was auch als Quellung bezeichnet wird. Die Quellung der Abdeckmasse und die kurzzeitige starke Erwärmung des Modules beim Einbau in den Kartengrundkörper, sind verantwortlich für hohe Ausschußraten nach dem Einbau. Dies ist insbesondere bei Chipmodulen der Fall, die einen großflächigen Chip besitzen. Solche Chips werden als Mikrokontroller und/oder Cryptokontroller bezeichnet.

Bisherige Maßnahmen, die Nachteile aus dem Stand der Technik auszuschalten, bestanden in der Entwicklung, Auswahl und Erprobung von Abdeckmassen, die eine geringe Aufnahme von Feuchtigkeit besitzen, sowie in Maßnahmen, die zu einer Erhöhung der Abdeckmassenadhäsion, wie beispielsweise höherer Rauhigkeit der Chipträgeroberfläche, führen. So wurden beispielsweise Abdeckmassen eingesetzt, die mit Haftvermittler (Silan-/Siloxan-Basis) versehen sind.

Der Erfindung liegt die Aufgabe zugrunde, ein Chipmodul für den Einbau in Chipkarten bereitzustellen, bei dem eine Delamination zwischen einer Abdeckmasse und einem elektronischen Bauelement mit daraus resultierendem Funktionsverlust des Chipmoduls bei einem Verbindungsverfahren zwischen Chipmodul und Kartenkörper unterbunden wird.

Die Lösung dieser Aufgabe geschieht durch Chipmodule mit den Merkmalen der Ansprüche 1 oder 4.

Zum Einbau eines Chipmodules in den Kartenkörper einer Chipkarte muß bei verschiedenen Verfahren eine bestimmte Wärmemenge von außen eingebracht werden. Dies geschieht durch externe, beispielsweise in einem Stempel erzeugte, Wärme, die durch Aufsetzen des Stempels auf das Chipmodul in dieses übergeleitet wird. Die Wärmeeinbringung hat die Temperaturerhöhung an den Orten bzw. Flächen zum Ziel, an denen etwa eine Klebeverbindung zwischen dem Träger des Chipmodules und dem Kartenkörper herzustellen ist. Eine Wärmeleitung in andere Bereiche des Chipmodules sollte minimiert werden. Da bei der Herstellung einer Klebeverbindung ein wärmeabgebender Hohlstempel auf den auf der flexiblen Folie angeordneten Kontakten aufsetzt und über diese die Wärmemenge in das Chipmodul einkoppelt wird, kann jedoch eine wesentliche Wärmeleitung in Richtung auf den Chip nicht unterbunden werden. Da die Wärmeleitfähigkeit der ebenfalls mit der flexiblen Trägerfolie in Kontakt stehenden Abdeckmasse gering ist, geht eine wesentliche Menge der eingebrachten Energie von der flexiblen Trägerfolie über eine Klebstoffschicht in den Chip. Dies führt nicht nur zur Erhitzung des Chips, sondern auch zur Delamination in dem Kontaktbereich zwischen Chip und Abdeckmasse.

Um dies zu unterbinden, wird eine Wärmeisolierschicht zwischen der Klebstoffschicht und dem Chip eingebracht. Eine weitere Lösung der Aufgabe sieht gezielt plazierte Aussparungen in den metallischen Kontakten vor, auf die ein Hohlstempel zur Wärmeeinleitung aufsetzt. Verhindert der Einsatz einer Wärmeisolierschicht zwischen dem Chip und der Klebstoffschicht, die den Chip mit dem Modul verbindet, die Wärmeleitung innerhalb des Modules in Richtung Chip, so verhindern Aussparungen in den metallischen Kontakten die laterale, d.h. in der Fläche der Metallkontakte liegende Wärmeleitung. Nachdem der Hohlstempel annähernd ringförmig in dem äußeren Bereich des Chipmoduls auf den metallischen Kontakten aufsetzt, und der Chip auf der gegenüberliegenden Seite des Trägers des Chipmodules annähernd konzentrisch zu den metallischen Kontakten angeordnet ist, liegt der Chip auch im inneren Bereich relativ zum Hohlstempel betrachtet. Davon ausgehend ist ersichtlich, daß ein senkrecht durch das flächig ausgebildete Modul hindurchgeführter Wärmestrom zur Herstellung einer Hot-Melt-Klebung gewünscht ist. Die Aussparungen innerhalb der metallischen Kontakte sind derart plaziert, daß eine parallel zum flächig ausgebildeten Chipmodul geführte Wärmeleitung innerhalb der elektrischen Kontakte nach innen durch die eingebrachten Aussparungen unterbunden wird. Dadurch wird die Durchwärmung des Chipmodules während der kurzzeitigen Hot-Melt-Einbauzeit durch konstruktive Maßnahmen verhindert. Die Schicht der metallischen Kontakte, die die beste Wärmeleitfähigkeit aufweist, wird somit in der entsprechenden Richtung teilweise unterbrochen. Die auf der Innenseite eines Chipmodules vorliegende Epoxy-Glasfaser-Verbundschicht besitzt eine um Größenordnungen geringere thermische Leitfähigkeit, wodurch diese Schicht hinsichtlich der oben genannten Zielsetzung keine Bedeutung hat. Die Aussparungen sind in der Regel Langlöcher, um eine entsprechend breite Wärmebarriere innerhalb des Umrisses eines Hohlstempels darzustellen.

Vorteilhafte Ausgestaltungen sind den Unteransprüchen zu entnehmen.

Im folgenden werden anhand von schematischen Figuren Ausführungsbeispiele beschrieben.
- Figur 1: zeigt eine ausschnittsweise Schnittdarstellung mit der relativen Positionierung eines Hohlstempels beim Einbau eines Chipmodules in einen Kartenkörper,
- Figur 2: zeigt eine Darstellung entsprechend Figur 1 mit einer zusätzlichen Wärmeisolierschicht zwischen flexibler Trägerfolie und Chip,
- Figur 3: zeigt eine Schnittdarstellung eines Chipmodules, wobei innerhalb der Schicht der Metallkontakte 10 Aussparungen 11 vorhanden sind,
- Figur 4: zeigt schematisch die Draufsicht auf die Metallkontakte, wobei die Aussparungen und der Umriß des Chips angedeutet sind.

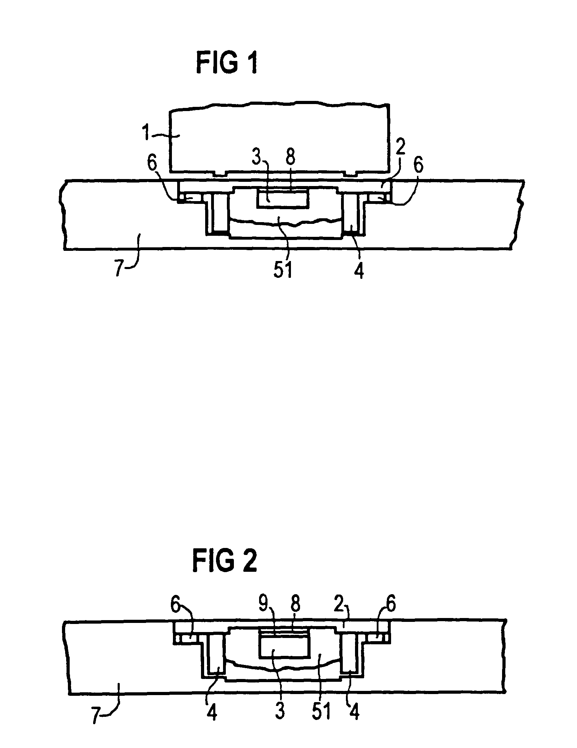

Mittels der Erfindung ist eine Delamination der Abdeckmasse im Chipbereich beim Hot-Melt-Einbauverfahren beim Einbau von Modulen mit einer Goldinsel in die Kartenkörper vermeidbar. Bei dem Hot-Melt-Moduleinbauverfahren wird mittels eines Hohlstempels 1 mit relativ hoher Temperatur von beispielsweise 200° C unter Krafteinwirkung mit entsprechender Zeitsteuerung ein Chipmodul entsprechend Figur 1 auf den Kartenkörper geklebt. Die Figur 1 zeigt dabei im einzelnen den Hohlstempel 1, der auf dem flexiblen Trägerband 2 des Chipmoduls aufsetzt. Da an dieser Stelle die nach außen sichtbaren Metallkontakte positioniert sind, wird der Hohlstempel 1 auf diese aufsetzen. Nach innen weist das Chipmodul eine Klebstoffschicht 8 auf, mittels der der Chip 3 auf dem Trägerband 2 positioniert und fixiert ist. Ein Versteifungsrahmen 4 ist ebenfalls auf dem Trägerband 2 angeordnet und umgibt den Chip 3. Die Abdeckmasse 51 schützt den Chip 3 und seine zu den Kontakten geführten elektrischen Verbindungen vor Korrosion und mechanischem Einfluß von außen. Das Chipmodul wird mittels des Hot-Melt-Klebstoffes 6 in den Kartenkörper 7 eingeklebt.

Um die in Figur 1 vorhandene Möglichkeit, daß eine wesentliche Wärmemenge vom Hohlstempel 1 über das Trägerband 2 und den Klebstoff 8 direkt in den Chip 3 fließt, auszuschließen, ist in der der Figur 1 entsprechenden Darstellung der Figur 2 zusätzlich eine Wärmeisolierschicht 9 eingebracht worden. Damit wird verhindert, daß die unterschiedlichen thermischen Ausdehnungskoeffizienten von Chip (beispielsweise Silizium), Abdeckmasse und flexiblem Trägerband zum Tragen kommen und Schäden durch starke thermomechanische Kräfte bei einer hohen Temperatur verursachen. Diese Kräfte treten auf, wenn hohe Temperaturen, beispielsweise beim Einbauverfahren des Chipmoduls in das Gesamtsystem eingebracht werden. Dies kann zu Delaminierungen führen. Die Abdeckmasse kann sich dabei vom Chip lösen und verursacht Funktionsausfälle des Modules, beispielsweise durch Beschädigung der elektrischen Leiter zwischen Chip und Außenkontakten.

Durch Aufbringen einer Polyimidschicht auf die Chiprückseite können die Delaminierungserscheinen eliminiert werden. Polyimid weist einen niedrigen Wärmeleitwert auf, so daß Polyimid als Hitzebarriere einsetzbar ist. Dadurch werden die thermomechanischen Kräfte zwischen Chip 3 und Abdeckmasse 5 reduziert. Während dessen wird die für die Klebung notwendige Wärme des Heizstempels 1 in den Hot-Melt-Klebstoff 6 fließen, um die Verbindung herzustellen. Das Polyimid wird im Waferprozeß auf die Scheibenrückseite aufgebracht. Die thermische Wärmeleitfähigkeit von Polyimid ist so gering, daß selbst eine Schichtdicke von nur 10 µm Polyimid ausreicht, wie Vorversuche ergeben haben.

Die Wärmeisolierschicht 9 ist aufgrund des Materialkennwertes für die Wärmeleitfähigkeit vorzugsweise eine Polyimidschicht. Die Verwendung von anderen Wärmeisolatoren ist jedoch genauso möglich. Da das Polyimid in einfacher Weise im Waferprozeß auf die Waferrückseite aufgebracht werden kann, ist diese Materialauswahl sehr vorteilhaft.

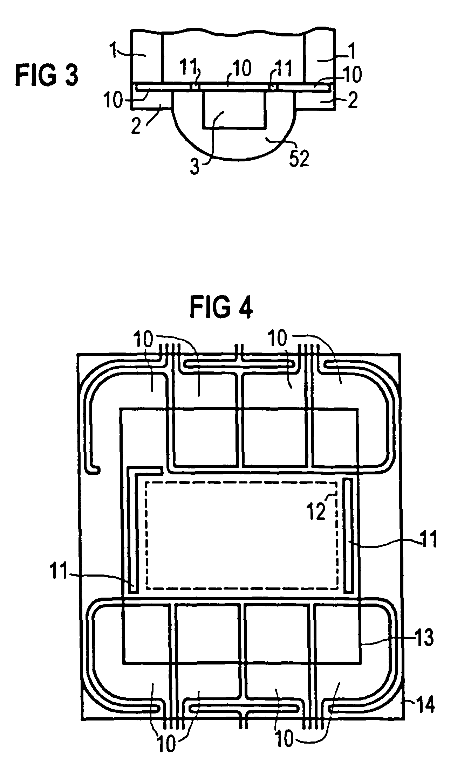

In Figur 3 ist ein Chipmodul in Verbindung mit einem auf sitzenden Hohlstempel 1 dargestellt. Das Trägerband 2 weist auf der einen Seite die Metallkontakte 10 auf und gegenüberliegend ungefähr konzentrisch dazu angeordnet, den Chip 3. Die Abdeckmasse 52 schützt die aktive Seite des Chips 3, sowie dessen Kontaktierung mit den Metallkontakten 10. Es ist deutlich sichtbar, daß mittels Aussparungen 11 ein lateraler, im Bild seitlich gerichteter, Wärmefluß vom Hohl stempel 1 in Richtung auf den Chip unterbunden wird. Ein im Schnitt von oben nach unten ausgerichteter Wärmefluß vom Hohl stempel 1 über die Metallkontakte 10 und über das Trägerband 2, wird nicht behindert.

In der Figur 4 werden die derzeit üblichen Kontakte einer Chipkarte dargestellt. Die Metallkontakte 10 sind im wesentlichen in zwei, relativ zum Chip 3 gegenüberliegenden Reihen angeordnet. Der Chipumriß 12 deutet die zentrale Lage des Chips 3 an. Der innere Umriß 13 des Hohlstempels 1 und der äußere Umriß 14 des Hohlstempels 1 bilden konzentrisch ineinanderliegende Rechtecke. Die als Langloch ausgebildeten Aussparungen 11 verhindern an den Stellen, an denen nicht ohnehin zur Begrenzung der einzelnen Metallkontakte 10 vorhandene Unterbrechungen in der Metallschicht vorgesehen sind, den Wärmefluß nach innen, d.h. in Richtung auf den relativ zur Aussparung 11 gegenüberliegend montierten Chip 3.

Die Erfindung kann sowohl auf Module mit einer Goldinsel angewandt werden, als auch auf andere Module, die keine derartige Goldinsel aufweisen.

## Patentansprüche

1. Chipmodul zum Einbau in einen Kartengrundkörper (7) einer Chipkarte, bestehend aus
- einem flexiblen Trägerband (2) mit guter Wärmeleitfähigkeit,
- einseitig auf dem Trägerband (2) aufgebrachten flächigen Metallkontakten (10),
- mindestens einem auf der den Kontakten gegenüberliegenden Seite des Trägerbandes (2) aufgebrachten elektronischen Bauelement (3), das elektrisch mit den Kontakten verbunden ist, und
- einer vorgegebenen Fläche auf dem Trägerband (2), über die das Chipmodul mit dem Kartengrundkörper (7) verbindbar ist,
**dadurch gekennzeichnet,**
daß zwischen dem elektronischen Bauelement (3) und dem Trägerband (2) eine Wärmeisolierschicht vorhanden ist.

2. Chipmodul nach Anspruch 1, **dadurch gekennzeichnet**, daß die Wärmeisolierschicht (9) aus Polyimid besteht.

3. Chipmodul nach Anspruch 2, **dadurch gekennzeichnet,** daß die Polyimidschicht eine Stärke von 10 µm aufweist.

4. Chipmodul zum Einbau in einen Kartengrundkörper (7) einer Chipkarte, bestehend aus
- einem flexiblen Trägerband (2),
- einseitig auf dem Trägerband (2) aufgebrachten flächigen, in zwei parallelen Reihen angeordneten Metallkontakten (10), wobei eine der Kontaktflächen mit einer zwischen den Kontaktreihen angeordneten Metallfläche einstückig ausgebildet ist
- mindestens einem auf der den Kontakten gegenüberliegenden Seite des Trägerbandes (2) aufgebrachten elektronischen Bauelement (3), das elektrisch mit den Kontakten (10) verbunden ist, und
- einer vorgegebenen Fläche auf dem Trägerband (2), über die das Chipmodul mit dem Kartengrundkörper (7) verbindbar ist,
**dadurch gekennzeichnet,**
daß innerhalb der Metallfläche senkrecht zu den Kontaktreihen (10) verlaufende Aussparungen (11) vorgesehen sind, die den Wärmefluß eines ringförmig im Außenbereich der Metallkontakte (10) und der Metallfläche aufsetzenden Hohlstempels (1) in Richtung auf das zentral montierte elektronische Bauelement (3) unterbinden.

## Claims

1. Chip module for incorporation in a basic card body (7) of a chip card, comprising
- a flexible carrier tape (2) with good heat-conduction capacity,
- flat-area metal contacts (10) applied to the carrier tape (2) on one side,
- at least one electronic component (3) which is applied on the side of the carrier tape (2) opposite the contacts and is electrically connected to the contacts, and
- a predetermined area on the carrier tape (2), via which the chip module can be bonded to the basic card body (7),
characterized in that a heat-insulating layer is present between the electronic component (3) and the carrier tape (2).

2. chip module according to Claim 1, characterized in that the heat-insulating layer (9) consists of polyimide.

3. chip module according to Claim 2, characterized in that the polyimide layer has a thickness of 10µm.

4. chip module for incorporation in a basic card body (7) of a chip card, comprising
- a flexible carrier tape (2),
- flat-area metal contacts (10) which are arranged in two parallel rows and are applied to the carrier tape (2) on one side, one of the contact surfaces being formed integrally with a metal surface arranged between the rows of contacts,
- at least one electronic component (3) which is applied on the side of the carrier tape (2) opposite the contacts and is electrically connected to the contacts (10), and
- a predetermined area on the carrier tape (2) via which the chip module can be connected to the basic card body (7),
characterized in that there are provided within the metal surface clearances (11) which run perpendicularly to the rows of contacts (10) and prevent the heat flow of a hollow punch (1), brought down in an annular form in the outer region of the metal contacts (10) and the metal surface, in the direction of the centrally mounted electronic component (3).

## Revendications

1. Module de puce destiné au montage dans un corps de base (7) d'une carte à puce, consistant en
- une bande support (2) flexible ayant une bonne conductivité thermique,
- des contacts métalliques (10) plans placés sur un côté de la bande support (2),
- au moins un composant électronique (3) placé sur le côté opposé aux contacts de la bande support (2), qui est relié électriquement aux contacts, et
- une surface prédéfinie sur la bande support (2), permettant de relier le module de puce au corps de base (7) de la carte,
**caractérisé en ce qu'**une couche d'isolation thermique est prévue entre le composant électronique (3) et la bande support (2).

2. Module de puce selon la revendication 1, **caractérisé en ce que** la couche d'isolation thermique (9) est en polyimide.

3. Module de puce selon la revendication 2, **caractérisé en ce que** la couche de polyimide a une épaisseur de 10 µm.

4. Module de puce destiné au montage dans un corps de base (7) d'une carte à puce, consistant en :
- une bande support (2) souple,
- des contacts métalliques (10) plans placés en deux rangées parallèles sur un côté de la bande support (2), l'une desdites surfaces de contact étant réalisée en une seule pièce avec une surface métallique disposée entre les rangées de contacts,
- au moins un composant électronique (3) placé sur le côté opposé aux contacts de la bande support (2), qui est relié électriquement aux contacts (10), et
- une surface prédéfinie sur la bande support (2), permettant de relier le module de puce au corps de base (7) de la carte,
**caractérisé en ce que** des évidements (11) perpendiculaires par rapport aux rangées de contacts (10) sont ménagés dans la surface métallique, qui empêchent le flux de chaleur d'un poinçon creux (1), venant se poser en anneau sur la périphérie des contacts métalliques (10) et de la surface métallique, de s'étendre en direction du composant électronique (3) monté au centre.
